Europäisches Patentamt

(19) European Patent Office

Office européen des brevets

(11) Publication number: **0 170 427**
**A2**

# (12) EUROPEAN PATENT APPLICATION

(21) Application number: 85304736.3

(22) Date of filing: 03.07.85

(51) Int. Cl.⁴: **G 01 R 33/032**

(30) Priority: 03.07.84 GB 8416864

(43) Date of publication of application:
05.02.86 Bulletin 86/6

(84) Designated Contracting States:
DE

(71) Applicant: Jackson, David Alfred
8 Woodland Way
Canterbury Kent CT2 7LS(GB)

(71) Applicant: Corke, Michael
1865 Brentwood Lane
Wheaton Illinois 60187(US)

(71) Applicant: Kersey, Alan David
17 Oakwood Road
Sturry, Canterbury Kent, CT2 0LU(GB)

(72) Inventor: Jackson, David Alfred
8 Woodland Way
Canterbury Kent CT2 7LS(GB)

(72) Inventor: Corke, Michael
1865 Brentwood Lane
Wheaton Illinois 60187(US)

(72) Inventor: Kersey, Alan David
17 Oakwood Road
Sturry, Canterbury Kent, CT2 0LU(GB)

(74) Representative: Cullis, Roger
Patent Department National Research Development
Corporation 101 Newington Causeway
London SE1 6BU(GB)

(54) Method of and apparatus for the measurement of magnetic fields.

(57) A magnetometer includes a twin fibre (2, 3) interfero-
meter, the fibres being coated with a layer of magnetostric-
tive material (6, 7) to cause the optical length of the fibres to
change under the influence of a field. Modulated light from a
laser source (1) interferes and the fringe pattern is detected
and used to control the signal in feedback circuits (25, 26).

EP 0 170 427 A2

128718

# METHOD OF AND APPARATUS

## FOR THE MEASUREMENT OF MAGNETIC FIELDS

This invention relates to the measurement of magnetic fields and, in particular, to the measurement of magnetic fields using apparatus incorporating optical fibres.

It is known to make measurements of the field strength of weak magnetic fibres by means of an interferometer incorporating fibre optic light guides which are subjected to magnetostrictive stress by the magnetic fields. Early work was concerned with measurement of relatively high frequency alternating fields (>100Hz), although the measurement of quasi-steady-state (d.c.) and low frequency alternating magnetic fields has been demonstrated by using the "small-signal" alternating field superimposed on a steady-state or low frequency field. This technique overcomes some problems associated with the sensitivity of the fibre to low frequency thermal and mechanical perturbations. There are practical difficulties associated with the amplitude and frequency of the calibration magnetic field signal, the linear range of the technique and variations in sensitivity caused by hysteresis effects.

These difficulties have now been overcome by means of a closed loop d.c. field/gradient field fibre magnetometer in which the dynamic magnetostrictive responsivity of the active sensing element is effectively maintained at zero by control of the total bias field using current feedback to a biasing coil. This nulling technique has the advantage that the system is less susceptible to drift and noise associated with the stability of the magnetic calibration signal used to measure the a.c. responsivity, and the closed loop operation of the system ensures a large linear dynamic range, and greatly reduces problems arising due to hysteresis effects in the active magnetostrictive sensing element.

According to the present invention there is provided apparatus for measuring the strength of a magnetic field comprising a source of optical radiation, a pair of fibre optic radiation guides arranged to carry radiation from said source through said magnetic field, magnetic field sensing means coupled to at least one of said radiation guides to cause the optical path length in said radiation to change in response to variations in the strength of the magnetic field through which said radiation guide passes, detector means fed from said combined means to generate a signal in dependence on interference between the radiation transferred by said radiation guides and feedback means controlled by said signal to cause the magnetic field surrounding at least one of said radiation guides to vary in dependence thereon.

The invention will now be described with reference to the accompanying drawing in which:-

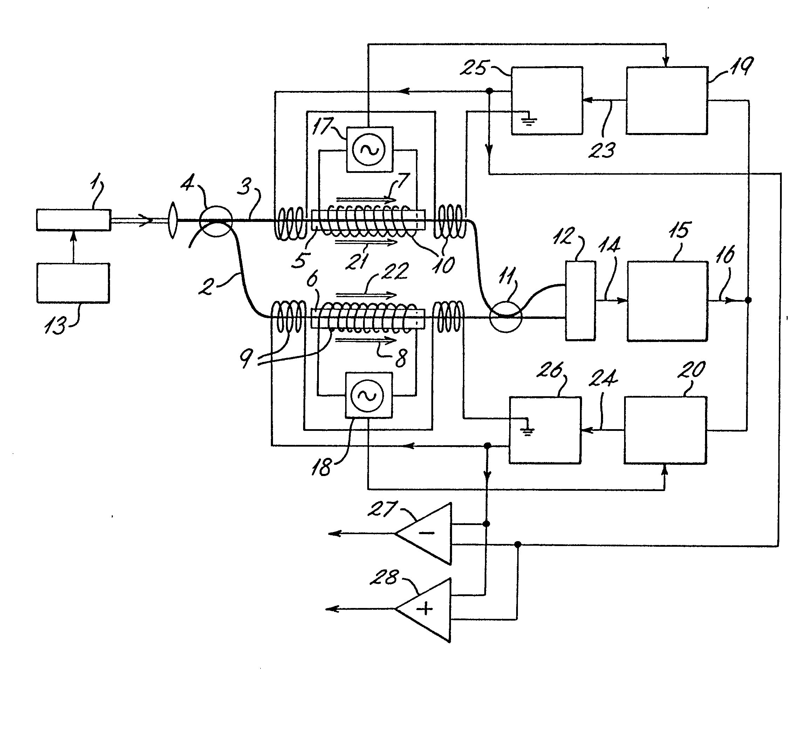

Figure 1 shows in diagrammatic form a closed-loop fibre optic magnetometer.

Referring now to the drawing, light from a laser source (1) is launched into a single-mode optical fibre Mach-Zehnder interferometer, being amplitude divided into the two fibre arms (2,3) by a fibre directional coupler (4). Sections (5,6) of fibre in each arm are bonded to or coated with a magnetostrictive material, such as nickel or certain forms of metallic glass, in order to form active magnetic field sensing regions. These fibre sections are then placed in separate magnetic fields $H_1$ and $H_2$ (7,8) generated using solenoid and helmholtz coil arrangements (9,10). Light in the two arms is combined using a second fibre directional coupler (11) and the interference signals generated at the interferometer outputs are detected using photodetectors (12). By modulating the emission frequency of the laser source using a suitable waveform generator (13) a pseudo-heterodyne signal recovery scheme is adopted which provides a carrier output signal (14) which contains as its relative phase the instantaneous optical phase information of the fibre interferometer. Demodulation of this carrier is achieved using either a phase tracking unit or a phase locked loop (15), and provides an output signal (16) directly related to the phase information of the optical fibre interferometer.

The magnetic fields $H_1$ and $H_2$ (7,8) applied to the sensing fibre regions (5,6) of the interferometer each consist of both a.c.

$(H_{ac}^1, H_{ac}^2)$ and d.c. $(H_{dc}^1, H_{dc}^2)$ components. The frequencies of the oscillators (17,18) used to generate the a.c. components of these fields, $f_1$ and $f_2$, are chosen such that $f_1 \sim f_2 \sim 1 - 10$ KHz and $f_1 \neq f_2$. These a.c. fields create periodic magnetostrictive straining of the fibres which in turn produce a modulation of the optical path lengths in the two fibre arms of the interferometer and give rise to output signals at the demodulator at the frequencies $f_1$ and $f_2$.

The magnitudes of the signals produced at each frequency are detected using synchronous detectors (19,20) tuned to the respective frequency. As a result of the nature of magnetostrictions in ferromagnetic materials the amplitude of the periodic magnet-straining produced in the two fibre arms by the a.c. fields, $H_{ac}^1$ and $H_{ac}^2$, is proportional to the total d.c. field present at each sensing region. If the external d.c. fields (21,22) (earths field) at each sensing region are denoted as $H_{ext}^1$ and $H_{ext}^2$ then the total d.c. fields at each sensing region are:

$$H_{total}^1 = H_{dc}^1 + H_{ext}^1$$

$$H_{total}^2 = H_{dc}^2 + H_{ext}^2$$

The output voltage (23) of the synchronous detector (19) tuned to $f_1$ is therefore proportional to the magnitude of the total d.c. field $(H_{dc}^1 + H_{ext}^1)$ experienced by the field sensing region (5) of fibre arm 1, and likewise the output (24) of the second synchronous detector (20) is proportional to $(H_{dc}^2 + H_{ext}^2)$.

In the closed loop system described here, the output voltages (23,24) of the synchronous detectors are integrated and fed back, using simple electronic circuits (25,26), to form the current supplied to the two d.c. field coils used to generate the fields $H_{dc}^1$ and $H_{dc}^2$. With an overall negative feedback arrangement this configuration has a stable operating point with the outputs (23,24) of the two synchronous detectors (19,20) at zero.

- 4 -

This condition, which corresponds to that of zero a.c. magnetostrictive responsitivity in the sensing regions, (5,6), arises when $H_{dc}^1 = -H_{ext}^1$ and $H_{dc}^2 = -H_{ext}^2$, i.e. $H_{total}^1 = H_{total}^2 = 0$. Gradient field information is then extracted from the difference in the voltages applied to the coils used to generate $H_{dc}^1$ and $H_{dc}^2$ obtained using a difference amplifier (27), whereas the mean total field information is obtained from the sum of these voltages via a summing amplifier (28).

105B

0170427

- 5 -

<u>CLAIMS</u>

1. Apparatus for measuring the strength of a magnetic field having an optical element which varies in dependence on the strength of a magnetic field wherein said apparatus comprises a source of radiation 1, a pair of fibre optic radiation guides (2,3) arranged to carry radiation from said source through said magnetic field 1, magnetic field sensing means (5,6) coupled to at least one of said guides to cause the optical path length in said guide to change in response to variations in the strength of the magnetic field (7,8) through which said radiation guide passes, combines means (11) to combine the radiation transmitted by each of said pair of fibre optic radiation guides, detector means (19,20) fed from said combined means to generate a signal in dependence on interference between the radiation transferred by said radiation guides and feedback means (25,26) controlled by said signal to cause the magnetic field surrounding at least one of said radiation guides to vary in dependence thereon.

2. Apparatus for measuring the strength of a magnetic field as claimed in Claim 1 wherein said magnetic field sensing means comprises a layer of magnetostrictive material bonded (5,6) to at least one of said radiation guides.

3. Apparatus for measuring the strength of a magnetic field as claimed in Claim 1 or Claim 2 wherein said source of optical radiation comprises a laser (1) having modulator (13) means coupled thereto.

4. Apparatus for measuring the strength of a magnetic field as claimed in Claim 3 wherein said detector means includes means (15) to generate an output signal dependent on the difference in phase of the radiation transmitted by said pair of light guides.

5. Apparatus for measuring magnetic field strength as claimed in Claim 4 including a single-mode optical fibre Mach-Zehnder interferometer.

6. A method of measuring the strength of a magnet field comprising placing a pair of fibre-optic radiation guides in the magnetic field, causing the length of the optical path in at least one of said guides to vary in dependence on the strength of said magnetic field and measuring changes in the interference patterns produced by the interaction of radiation transmitted by each of said pair of radiation guides.

105D

《